# EUROPÄISCHE PATENTSCHRIFT

(11) **EP 1 646 779 B1**
(45) Veröffentlichungstag und Bekanntmachung des Hinweises auf die Patenterteilung: **15.10.2008**
(21) Anmeldenummer: 04736913.7
(22) Anmeldetag: 16.06.2004
(51) Int. Cl.: F02D 41/34, F02P 7/07

(54) **VERFAHREN ZUR ERZEUGUNG ELEKTRISCHER PULSE**
METHOD FOR THE GENERATION OF ELECTRICAL PULSES
PROCEDE DE GENERATION D'IMPULSIONS ELECTRIQUES

(30) Priorität: 22.07.2003 DE 10333318
(43) Veröffentlichungstag der Anmeldung: 19.04.2006
(73) Patentinhaber: Continental Automotive GmbH, 30165 Hannover (DE)
(72) Erfinder: ASPELMAYR, Josef, 4312 Ried/Riedmark (DE); FALKE, Bernd, 93080 Pentling (DE)
(86) Internationale Anmeldenummer: PCT/EP2004/051127
(87) Internationale Veröffentlichungsnummer: WO 2005/010336

(56) Entgegenhaltungen:
- EP-A- 0 671 556
- WO-A-02/08599
- DE-A- 10 159 795
- SHEER, ROBIN: "Using the 80C196KB" 30. November 1991 (1991-11-30), INTEL , XP002296671 Seite 17 - Seite 20; Abbildungen 7-1,7-2,7-3,7-4,8-1,8-2 Seite 33 - Seite 35

## Beschreibung

Die Erfindung bezieht sich auf ein Verfahren zur Erzeugung elektrischer Pulse, wobei aus einer Referenzquelle Eingangssignale in Berechnungsmittel eingespeist werden, die Berechnungsmittel programmgesteuert anhand von eingegebenen Parametern von den Eingangssignalen abhängige Steuerungswerte zur Ansteuerung einer Pulserzeugungselektronik berechnen und die Pulserzeugungselektronik an wenigstens einem Ausgang in Abhängigkeit von den Steuerungswerten eine zeitliche Folge von elektrischen Spannungsniveaus erzeugt.

Die Problematik der Erzeugung elektrischer Pulse ergibt sich in vielen technischen Systemen. Sie ist beispielsweise von Kraftfahrzeugen her bekannt, wo ein rotierendes mechanisches System, nämlich eine Komponente des Kraftfahrzeugmotors, als Referenzquelle dient, von der zyklisch wiederholte Signale als Referenz für die Erzeugung von elektrischen Steuerpulsen genutzt werden, die ihrerseits zur Ansteuerung weiterer elektromechanischer Vorrichtungen, wie etwa Einspritzventilen, Injektoren etc. verwendet werden. Gemäß der Terminologie des Oberbegriffs von Anspruch 1 lassen sich dabei funktional drei Ebenen unterscheiden. Die eigentlichen elektrischen Pulse entstehen als zeitliche Folge unterschiedlicher elektrischer Spannungsniveaus am Ausgang einer eigentlichen Pulserzeugungselektronik. Diese kann beispielsweise eine Anordnung von Transistoren und anderen elektronischen Bauteilen umfassen, die in geeigneter Weise durch Eingabe von Steuerungswerten angesteuert werden. Die Steuerungswerte sind das Ergebnis einer Berechnung durch Berechnungsmittel, z.B. einen Mikroprozessor, die einerseits Referenzsignale als Eingangsdaten von einer zyklischen Referenzquelle erhalten und andererseits bestimmte Rechenregeln und Parameter zur Definition der zu erzeugenden Pulse, so dass eine Umrechnung dieser Informationen in für die spezielle Pulserzeugungselektronik geeignete Steuerungswerte erfolgen kann. Man beachte, dass die Aufspaltung in drei funktionale Ebenen nur der Erläuterung im Rahmen der vorliegenden Beschreibung dient, dass bei der konkreten, technischen Umsetzung jedoch beispielsweise Berechnungsmittel und Pulserzeugungselektronik als gemeinsame Vorrichtung, beispielsweise als Interface-Karte oder ähnliches ausgeführt sein können.

Bei gattungsgemäßen Vorrichtungen nach dem Stand der Technik werden die Pulse stets in festgelegter Weise, d.h. durch festgelegte Parameter, definiert, und die Definitionen unterschiedlicher Pulse unterscheiden sich lediglich in der Größe der Definitionsparameter. So wird ein Puls häufig durch seinen Beginn und seine Dauer definiert, wobei der Beginn als ein Winkel und die Dauer als eine Zeit beschrieben wird. Eine andere bekannte Definitionsmöglichkeit liegt in der Beschreibung des Pulses durch sein Ende und seine Dauer, wobei das Ende als Winkel und die Dauer als Zeit beschrieben wird. Schließlich ist es bekannt, einen einzelnen Puls durch seinen Beginn und sein Ende zu beschreiben, wobei beide Parameter die Form eines Winkels haben. Die konkret gewählte Definitionsart hängt ab von den Steuerungswerten, welche die Pulserzeugungselektronik zu ihrer Ansteuerung verlangt.

Diese Festlegung birgt einen wesentlichen Nachteil. Die Definitionen unterschiedlicher Pulse stammen in der Regel aus mathematischen Berechnungen, welche spezielle physikalische Vorgänge abbilden. Ändern sich beispielsweise die physikalischen Vorgänge während des Betriebs des Gesamtsystems kann es sein, dass geänderte Pulse berechnet und erzeugt werden müssen, wobei die mathematische Beschreibung der geänderten physikalischen Vorgänge am günstigsten mittels einer angepassten Pulsdefinition mit angepassten Parametern erfolgen würde. Statt dessen ist es bei bekannten Systemen lediglich möglich, die Größe der festgelegten Parameter zu ändern, so dass eine Pulsdefinition herangezogen werden muss, die sich nicht in natürlicher Weise aus der mathematischen Modellierung der zugrundeliegenden physikalischen Vorgänge ergibt. Dies führt zu aufwendiger Programmierung und längeren Berechnungszeiten.

Es ist eine Aufgabe der vorliegenden Erfindung, ein gattungsgemäßes Verfahren derart weiterzubilden, dass die vorgenannten Probleme des Standes der Technik überwunden werden, insbesondere ein Verfahren anzugeben, das eine größere Flexibilität bei der Definition der zu erzeugenden Pulse ermöglicht. Diese Aufgabe wird in Verbindung mit den Merkmalen des Oberbegriffs von Anspruch 1 dadurch gelöst, dass die eingegebenen Parameter jeweils ein Wertepaar umfassen, von dem ein Wert eine Größe des eingegebenen Parameters und ein anderer Wert einen Typ des eingegebenen Parameters repräsentiert und die Verarbeitung der Größe des Parameters in den Berechnungsmitteln in Abhängigkeit von dem Typ des eingegebenen Parameters erfolgt.

Erfindungsgemäß werden die Parameter zur Definition der Pulse jeweils als Wertepaar eingegeben, von dem ein Wert, wie bisher, die Größe des Parameters repräsentiert. Ein Zusatzwert gibt den Typ des Parameters an, d.h. ob es sich beispielsweise um einen Winkel, eine Zeit oder eine sonstige Art von Parameter handelt. Die Berechnungsmittel sind in der Lage, anhand des Zusatzwertes den Größenwert des Parameters richtig zu kategorisieren und zu interpretieren und die geeigneten Unterroutinen zur Berechnung der Steuerwerte zur Ansteuerung der eigentlichen Pulserzeugungselektronik durchzuführen.

Vorteilhafterweise ist vorgesehen, dass jeder von der Pulserzeugungselektronik auszugebende Puls mittels zweier Parameter definiert ist. Dies ist die zur Definition eines Pulses notwendige und hinreichende Parameteranzahl. Wie erwähnt, sind die Berechnungsmittel in der Lage, anhand der Zusatzwerte jedes einzelnen Parameters die eingegebenen Parameter richtig zu kategorisieren. Sie sind vorzugsweise weiter in der Lage, aus der Kombination der Typen des zur Definition eines Pulses eingegebenen Parameterpaares die geeigneten Routinen zur Berechnung der Steuerwerte für die Pulserzeugungselektronik zu wählen und durchzuführen.

Die zur Definition eines Pulses verwendeten Parameter können Zeit- und/oder Winkelgrößen repräsentieren. Dabei kann ein Puls beispielsweise durch eine Winkelgröße und eine Zeitgröße definiert werden. So ist es etwa möglich, die Position des Pulses anhand des Winkels des Pulsanfangs relativ zu einem Referenzwinkel sowie die Pulsdauer als Zeit anzugeben. Ebenso ist es möglich, die Pulsposition als Winkel des Pulsendes relativ zu einem Referenzwinkel und die Pulsdauer als (negative) Zeit anzugeben. Der Referenzwinkel kann ein absoluter Referenzwinkel, z.B. ein oberer Totpunkt eines als Referenzquelle dienenden Motors, sein. Andererseits kann als Referenzwinkel auch ein charakteristischer Wert eines benachbarten Pulses dienen. Bei einem anderen Ansatz, der auch zu einer Pulsdefinition mittels einer Winkel- und einer Zeitgröße führen kann, werden nicht eine Position und eine Pulsdauer, sondern zwei Positionen, nämlich die einer abfallenden und die einer ansteigenden Flanke, bestimmt. Ohne Beschränkung der Allgemeinheit wird im Folgenden davon ausgegangen, dass es sich um negative Pulse handelt, deren abfallende Flanke zeitlich vor der ansteigenden Flanke liegt. Die Erfindung ist selbstverständlich auch auf positive Pulse mit umgekehrter. Reihenfolge der abfallenden und ansteigenden Flanke übertragbar.

Bei einer anderen bevorzugten Ausführungsform des erfindungsgemäßen Verfahrens ist vorgesehen, dass zur Definition eines Pulses zwei Winkelgrößen verwendet werden. Hier kann beispielsweise vorgesehen sein, die Position des Pulsbeginns als Winkel relativ zu einem Referenzwinkel und die Pulsdauer als Differenzwinkel anzugeben. Ebenso ist es möglich, die Position des Pulsendes als Winkel relativ zu einem Referenzwinkel und die Pulsdauer als (negativen) Differenzwinkel anzugeben. Anstelle der Position und Pulsdauer lässt sich auch bei dieser Ausführungsform ein Puls durch Angabe seiner abfallenden und seiner ansteigenden Flanke beschreiben, die dann jeweils als Winkel relativ zu einem Referenzwinkel definiert sind. Auch hier gilt, dass der Referenzwinkel sowohl ein absoluter Referenzwinkel als auch ein auf einen Nachbarpuls bezogener Winkel sein kann.

Schließlich ist es möglich, wie bei einer weiteren bevorzugten Ausführungsform des erfindungsgemäßen Verfahrens vorgesehen, dass zur Definition eines Pulses zwei Zeitgrößen verwendet werden. In diesem Fall kann beispielsweise die Position des Pulsbeginn als eine erste Zeit und die Pulsdauer als eine zweite Zeit angegeben werden. Gemäß dem zweiten genannten Ansatz können auch die beiden Flanken eines Pulses jeweils durch einen Zeitwert angegeben werden. Die Zeitangabe kann dabei jeweils relativ zu einem zeitlich vorangehenden Zeitpunkt oder relativ zu einem nachfolgenden Zeitpunkt erfolgen, was zur Angabe von positiven bzw. negativen Zeiten führt. Dies ermöglicht es, die Pulse relativ zu absoluten Referenzzeitpunkten, relativ zu benachbart vorangehenden oder relativ zu benachbart nachfolgenden Pulsen zu definieren.

Durch die erfindungsgemäß vorgesehene Vielfalt der Möglichkeiten zur Definition der zu erzeugenden Pulse kann das Gesamtsystem besonders flexibel gestaltet werden und die Pulsdefinition kann jeweils in der Weise erfolgen, wie sie sich am günstigsten aus der mathematischen Modellierung des zugrundeliegenden physikalischen Problems bzw. der physikalischen Gegebenheiten ergibt.

Bei einer bevorzugten Ausführungsform des erfindungsgemäßen Verfahrens ist vorgesehen, dass die Definition eines Pulses während verschiedener Verfahrensdurchläufe unterschiedlich ist. Wie bereits erwähnt, ist nämlich eine Änderung der Pulsdefinition häufig dann erforderlich, wenn sich physikalische Gegebenheiten des Gesamtsystems ändern. Häufig sind die Änderungen von einer Art, die eine geänderte Modellierung der physikalischen Gegebenheiten erforderlich macht. Diese kann wiederum eine geänderte Definitionsweise der zu erzeugenden Pulse günstig erscheinen lassen. Die vorliegende Erfindung macht es möglich, stets die optimierte Definitionsweise zu verwenden, anstatt, wie im Stand der Technik, an einer festgelegten Pulsdefinitionsweise festhalten zu müssen und lediglich die Parametergrößen ändern zu können.

Das oben als "Gesamtsystem" bezeichnete System wird häufig ein elektromechanisches System sein, dessen aktuelle physikalische Bedingungen, z.B. bedingt durch einen speziellen Betriebszustand, die optimale Definitionsweise der Parameter vorgibt. Besonders häufig wird dabei insbesondere die Referenzquelle ein rotierendes mechanisches System, wie etwa rotierende Komponenten des Motors eines Kraftfahrzeugs, umfassen.

Man beachte, dass, obwohl im Rahmen dieser Beschreibung stets auf einzelne Pulse und deren Definition Bezug genommen wird, es für die vorliegende Erfindung nicht zwingend erforderlich ist, dass jeder einzelne erzeugte Puls von der Berechnungseinheit aufgrund von eigenen Eingabewerten individuell berechnet wird. Selbstverständlich ist es auch möglich, die Neuberechnung lediglich bei Definitions- oder Größenänderungen durchzuführen.

Weitere Einzelheiten der vorliegenden Erfindung ergeben sich aus der nachfolgenden, ausführlichen Beschreibung im Zusammenhang mit den Zeichnungen, in denen
- Figur 1: ein Baumdiagramm zur Erläuterung der erfindungsgemäßen Pulsdefinition darstellt,
- Figur 2: ein funktionales Blockdiagramm zur Verdeutlichung des erfindungsgemäßen Verfahrens darstellt,
- Figur 3: vier Beispiele einer möglichen Pulsdefinition darstellt,
- Figur 4: vier weitere Beispiele einer möglichen Pulsdefinition darstellt,
- Figur 5: vier weitere Beispiele einer Pulsdefinition darstellt und
- Figur 6: ein Beispiel der Definition einer Pulsfolge darstellt.

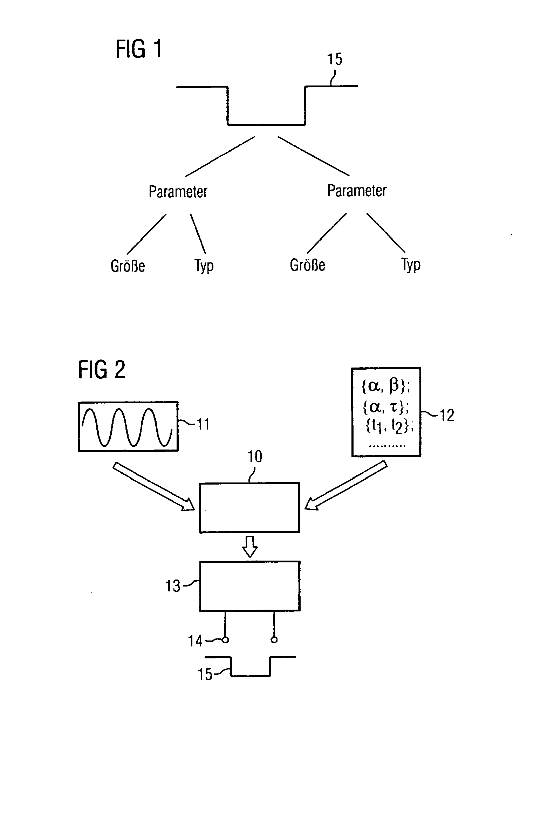

Figur 1 zeigt schematisch den Aufbau einer erfindungsgemäßen Pulsdefinition. Jeder Puls 15 wird vorzugsweise mittels zweier Parameter definiert, die ihrerseits jeweils als Wertepaar in die Berechnungsmittel eingegeben werden. Jedes Wertepaar umfasst einen Wert für die eigentliche Parametergröße und einen Zusatzwert zur Bestimmung des Parametertyps (z. B. Winkel, Zeit etc.). Man beachte, dass der Begriff der Eingabe im Rahmen dieser Beschreibung weit zu verstehen ist und das Übernehmen der Werte von jeder geeigneten Art Schnittstellen (z.B. Softwareschnittstelle, Hardwareschnittstelle, eigene Berechnung etc. ) umfasst.

Figur 2 zeigt ein funktionales Blockdiagramm des erfindungsgemäßen Verfahrens. Ein Berechnungsmittelblock 10 erhält Eingangswerte einerseits von einer Referenzquelle 11. Hierzu ist jedes harmonisch oszillierende System, insbesondere rotierende System, wie etwa der Motor eines Kraftfahrzeugs, geeignet, wobei lediglich charakteristische Werte, die z.B. die jeweils oberen Totpunkte o.ä. bezeichnen, an die Berechnungsmittel 10 übertragen werden müssen. Andererseits erhalten die Berechnungsmittel 10 von einer Parameterquelle 12 gemäß Figur 1 aufgebaute Pulsdefinitionen. Verschiedene Kombinationen von Winkeln (α, β) und/oder Zeitwerten (τ,t₁,t₂) symbolisieren beispielhaft mögliche Parameterkombinationen.

Aus den Pulsdefinitionen berechnen die Berechnungsmittel unter Verwendung der Referenzwerte von der Referenzquelle 11 Steuerwerte, welche zur Ansteuerung der eigentlichen Pulserzeugungselektronik 13 verwendet werden. Als Antwort auf die Eingabe der Steuerwerte stellt die Pulserzeugungselektronik 13 an ihren Ausgängen 14 eine Folge unterschiedlicher elektrischer Spannungsniveaus bereit, welche die angestrebte Pulsfolge 15 darstellen. Wie bereits erwähnt, wird die funktionale Aufspaltung, wie sie in Figur 2 dargestellt ist, nur zur besseren Erläuterung der vorliegenden Erfindung vorgenommen. Tatsächlich realisierte Systeme können mehrere der gezeigten Einheiten gemeinsam oder in einer anderen Aufteilung implementieren.

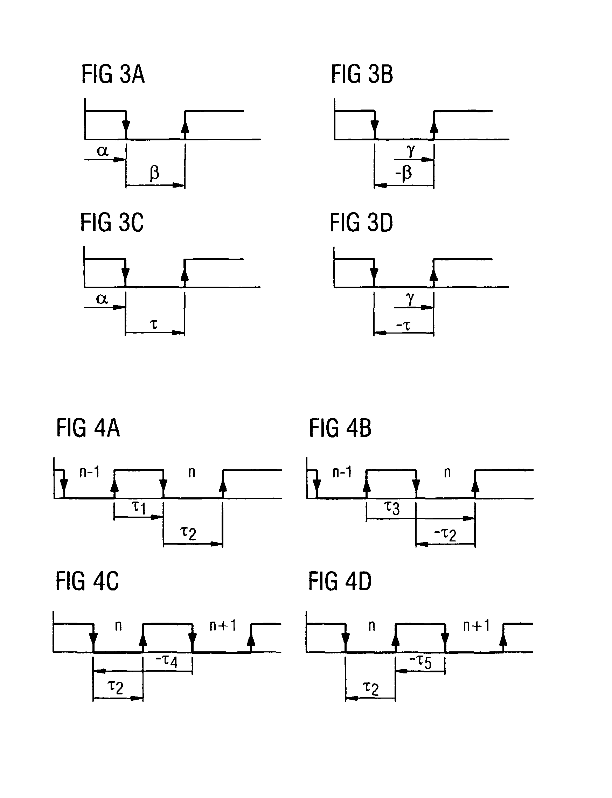

Figur 3 stellt vier Möglichkeiten der Pulsdefinition durch Pulsposition und Pulsdauer dar, wobei jeweils mindestens ein Winkelparameter Anwendung findet. Figur 3a zeigt die Pulsdefinition durch Angabe der Position des Pulsbeginns als Winkel α relativ zu einem Referenzwinkel und die Pulsdauer durch Angabe eines Differenzwinkels β relativ zu dem Positionswinkel α.

Figur 3b zeigt eine Pulsdefinition durch Angabe des Pulsendes als Winkel γ relativ zu einem Referenzwinkel und Angabe der Pulsdauer als negativen Differenzwinkel -β relativ zu dem Positionswinkel γ.

Figur 3c zeigt, wie Figur 3a, eine Pulsdefinition durch Angabe des Pulsbeginns als Winkel α relativ zu einem Referenzwinkel. Die Pulsdauer ist hier jedoch als eine Zeit τ angegeben.

Figur 3d zeigt, wie Figur 3b, eine Pulsdefinition durch Angabe des Pulsendes als Winkel γ relativ zu einem Referenzwinkel. Die Paulsdauer ist hier jedoch als negative Zeit -τ angegeben.

Figur 4 zeigt Möglichkeiten der Pulsdefinition von Puls n durch Verwendung zweier Zeitparameter. Figur 4a zeigt dabei die Pulsdefinition durch Angabe des Pulsbeginns als Zeit τ₁ relativ zu einer Referenzzeit, insbesondere zum Ende eines vorangehenden Pulses n-1. Die Pulsdauer wird als Zeit τ₂ angegeben.

Figur 4b zeigt eine Pulsdefinition durch Angabe des Pulsendes als Zeit τ₃ relativ zu einem Referenzzeitpunkt, insbesondere zum Ende des vorangegangenen Pulses n-1. Die Pulsdauer ist hier als negative Zeit -τ₂ angegeben.

Figur 4c zeigt eine Pulsdefinition durch Angabe des Pulsbeginns als negative Zeitangabe -τ₄ relativ zu einem zeitlich späteren Referenzzeitpunkt, hier insbesondere relativ zum Beginn des nachfolgenden Pulses n+1. Die Pulsdauer ist als Zeit τ₂ angegeben.

Figur 4d zeigt eine Pulsdefinition durch Angabe des Pulsendes als negative Zeit -τ₅ relativ zu einem zeitlich später erfolgenden Referenzzeitpunkt, hier insbesondere relativ zum Beginn des nachfolgenden Pulses n+1. Die Pulsdauer ist hier als negative Zeit -τ₂ angegeben.

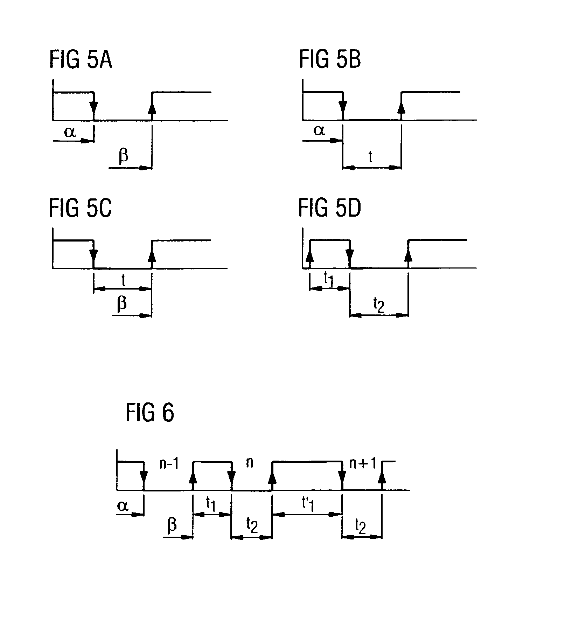

Figur 5 zeigt Beispiele zur Pulsdefinition, bei denen nicht Pulsposition und Pulsdauer angegeben werden, sondern die Lagen der abfallenden und der ansteigenden Kante. Bei den in diesem Beispiel gezeigten negativen Pulsen geht die abfallende Flanke der Ansteigenden zeitlich voran. Der Fachmann wird jedoch bei der Übertragung auf positive Pulse, bei denen die ansteigende Flanke der Abfallenden zeitlich vorangeht, keine Schwierigkeiten haben. Figur 5a zeigt eine Pulsdefinition, bei der abfallende und ansteigende Flanke jeweils als Winkel α bzw. β relativ zu einem Referenzwinkel definiert ist.

In dem Beispiel von Figur 5b wird die Lage der abfallenden Flanke ebenfalls als Winkel α relativ zu einem Referenzwinkel definiert, während die Lage der ansteigenden Flanke als eine Zeit t relativ zur abfallenden Flanke beschrieben ist.

Figur 5c zeigt die Bestimmung der ansteigenden Flanke als Winkel β relativ zu einem Referenzwinkel und die Bestimmung der abfallenden Flanke als Zeitangabe t relativ zur ansteigenden Flanke.

Figur 5d schließlich zeigt die Bestimmung der abfallenden Flanke als Zeitangabe t₁ relativ zu einem zeitlich vorangehenden Ereignis, hier insbesondere zur ansteigenden Flanke des zeitlich vorangehenden Pulses. Die ansteigende Flanke wird in diesem Beispiel beschrieben als Zeitangabe t₂ relativ zur abfallenden Flanke.

Figur 6 schließlich zeigt ein Beispiel einer Pulsfolge, bei der die einzelnen Pulse in unterschiedlicher Weise definiert sind. Puls n-1 ist definiert durch die Angabe eines Winkels α für seine abfallende Flanke sowie eines weiteren Winkels β für seine ansteigende Flanke. Beide Winkel α, β sind dabei auf einen nicht dargestellten Referenzwert bezogen. Der Puls n-1 entspricht einem Beispiel gemäß Figur 5a. Der folgende Puls n ist definiert durch eine Zeitangabe t₁ für seine abfallende Flanke, wobei diese Zeitangabe relativ zu der ansteigenden Flanke des vorangehenden Pulses n-1 bestimmt ist. Die ansteigende Flanke von Puls n ist als Zeit t₂ relativ zur abfallenden Flanke von Puls n definiert. Dies entspricht einer Pulsdefinition gemäß Figur 5d. Schließlich ist der zeitlich nachfolgende Puls n+1 in gleicher Weise definiert wie Puls n, wobei sich jedoch die Größe des Zeitparameters t'₁ zur Bestimmung der abfallenden Flanke verändert, während die Größe des Zeitparameters t₂ zur Bestimmung der ansteigenden Flanke unverändert bleibt.

Natürlich stellen die beschriebenen und in den Figuren gezeigten Ausführungsformen der vorliegenden Erfindung lediglich besonders günstige und vorteilhafte Ausführungsbeispiele dar, die lediglich der Illustration der Erfindung dienen und deren Umfang keineswegs einschränken sollen. Insbesondere ist es möglich, anstelle der oder zusätzlich zu den erwähnten Winkel- und Zeitangaben andere physikalische oder mathematischen Größen zur Definition der Pulse zu verwenden.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. Verfahren zur Erzeugung elektrischer Pulse, wobei
- aus einer Referenzquelle (11) Eingangssignale in Berechnungsmittel (10) eingespeist werden,
- die Berechnungsmittel (10) programmgesteuert anhand von eingegebenen Parametern von den Eingangssignalen abhängige Steuerungswerte zur Ansteuerung einer Pulserzeugungselektronik (13) berechnen, wobei ein Puls jeweils von einer Mehrzahl eingegebener Parameter definiert wird,
- und die Pulserzeugungselektronik (13) an wenigstens einem Ausgang (14) in Abhängigkeit von den Steuerungswerten eine zeitliche Folge von elektrischen Spannungsniveaus erzeugt,
wobei die eingegebenen Parameter jeweils ein Wertepaar umfassen, von dem ein erster Wert eine Größe des eingegebenen Parameters und ein Zusatzwert einen Typ des eingegebenen Parameters repräsentiert und die Verarbeitung der Größe des Parameters in den Berechnungsmitteln (10) in Abhängigkeit von dem Typ des eingegebenen Parameters erfolgt,
**dadurch gekennzeichnet,**
**dass** die Definition eines Pulses (15) während verschiedener Verfahrensdurchläufe durch Eingabe unterschiedlicher Zusatzwerte wenigstens eines der den Puls definierenden Parameter unterschiedlich ist.

2. Verfahren nach Anspruch 1,
**dadurch gekennzeichnet,**
**dass** jeder von der Pulserzeugungselektronik (13) auszugebende Puls (15) mittels zweier Parameter definiert ist.

3. Verfahren nach einem der vorangehenden Ansprüche,
**dadurch gekennzeichnet,**
**dass** die zur Definition eines Pulses (15) verwendeten Parameter Zeit- und/oder Winkelgrößen repräsentieren.

4. Verfahren nach Anspruch 3,
**dadurch gekennzeichnet,**
**dass** zur Definition eines Pulses (15) eine Winkelgröße und eine Zeitgröße verwendet wird.

5. Verfahren nach Anspruch 3,
**dadurch gekennzeichnet,**
**dass** zur Definition eines Pulses (15) zwei Winkelgrößen verwendet werden.

6. Verfahren nach Anspruch 3,
**dadurch gekennzeichnet,**
**dass** zur Definition eines Pulses (15) zwei Zeitgrößen verwendet werden.

7. Verfahren nach einem der vorangehenden Ansprüche,
**dadurch gekennzeichnet,**
**dass** die eingegebenen Parameter in Abhängigkeit von physikalischen Bedingungen eines elektromechanischen Systems berechnet werden.

8. Verfahren nach einem der vorangehenden Ansprüche,
**dadurch gekennzeichnet,**
**dass** die Referenzquelle (11) ein rotierendes mechanisches System umfasst.

## Claims

1. Method for the generation of electrical pulses, in which
- input signals from a reference source (11) are fed into calculation means (10),
- under program control using entered parameters the calculation means (10) calculate control values dependent on the input signals for controlling a pulse generation circuit (13), whereby a pulse is defined in each instance by a plurality of entered parameters,
- and the pulse generation circuit (13) generates a temporal sequence of electrical voltage levels at at least one output (14) as a function of the control values,
whereby the entered parameters in each case comprise a pair of values, of which a first value represents a size for the entered parameter and another value represents a type for the entered parameter, and the processing of the size for the parameter in the calculation means (10) takes place as a function of the type of the entered parameter,
**characterised in that**
the definition of a pulse (15) is different during different cycles of the method by entering different values of at least one of the parameters defining the pulse.

2. Method according to claim 1,
**characterised in that**
each pulse to be output (15) by the pulse generation circuit (13) is defined by means of two parameters.

3. Method according to one of the preceding claims,
**characterised in that**
the parameters used for the definition of a pulse (15) represent time size and angle size.

4. Method according to claim 3,
**characterised in that**
an angle size and a time size are used for the definition of a pulse (15).

5. Method according to claim 3,
**characterised in that**
two angle sizes are used for the definition of a pulse (15).

6. Method according to claim 3,
**characterised in that**
two time sizes are used for the definition of a pulse (15).

7. Method according to one of the preceding claims,
**characterised in that**
the entered parameters are calculated as a function of physical conditions of an electromechanical system.

8. Method according to one of the preceding claims,
**characterised in that**
the reference source (11) comprises a rotating mechanical system.

## Revendications

1. Procédé de production d'impulsions électriques, dans lequel
- des signaux d'entrée sont transférés d'une source de référence (11) dans des moyens de calcul (10),
- les moyens de calcul (10) calculent, sous la commande d'un programme et sur la base de paramètres mémorisés, des valeurs de commande dépendant des signaux d'entrée et destinées à commander une électronique (13) de production d'impulsions, chaque impulsion étant définie par une pluralité de paramètres mémorisés,
- et l'électronique (13) de production d'impulsions produit, sur au moins une sortie (14), en fonction des valeurs de commande, une suite temporelle de niveaux de tension électrique,
et dans lequel les paramètres mémorisés comprennent chacun une paire de valeurs, dont une première valeur représente une grandeur du paramètre mémorisé et une valeur additionnelle représente un type du paramètre mémorisé et le traitement de la grandeur du paramètre a lieu dans les moyens de calcul (10) en fonction du type du paramètre mémorisé,
**caractérisé**
**en ce que** la définition d'une impulsion (15) varie au cours de différentes exécutions du procédé sous l'effet de l'entrée de différentes valeurs additionnelles d'au moins un des paramètres définissant l'impulsion.

2. Procédé selon la revendication 1,
**caractérisé**
**en ce que** chacune des impulsions (15) sortant de l'électronique (13) de production d'impulsions est définie au moyen de deux paramètres.

3. Procédé selon l'une quelconque des revendications précédentes,
**caractérisé**
**en ce que** les paramètres utilisés pour la définition d'une impulsion (15) représentent des grandeurs temporelles et/ou angulaires.

4. Procédé selon la revendication 3,
**caractérisé**
**en ce que,** pour la définition
d'une impulsion (15), on utilise une grandeur angulaire et une grandeur temporelle.

5. Procédé selon la revendication 3,
**caractérisé**
**en ce que,** pour la définition d'une impulsion (15), on utilise deux grandeurs angulaires.

6. Procédé selon la revendication 3,
**caractérisé**
**en ce que**, pour la définition d'une impulsion (15), on utilise deux grandeurs temporelles.

7. Procédé selon une des revendications précédentes,
**caractérisé**
**en ce que** les paramètres mémorisés sont calculés en fonction de conditions physiques d'un système électromécanique.

8. Procédé selon l'une quelconque des revendications précédentes,
**caractérisé**
**en ce que** la source de référence (11) comprend un système mécanique rotatif.
